# EUROPÄISCHE PATENTSCHRIFT

(11) **EP 2 882 991 B1**
(45) Veröffentlichungstag und Bekanntmachung des Hinweises auf die Patenterteilung: **05.10.2016**
(21) Anmeldenummer: 13737597.8
(22) Anmeldetag: 16.07.2013
(51) Int. Cl.: F16M 11/08, F16M 11/10, F16M 13/00

(54) **HALTEVORRICHTUNG FÜR EIN TABLET-COMPUTER**
HOLDING DEVICE FOR A TABLET COMPUTER
MONTURE POUR UNE TABLETTE ÉLECTRONIQUE

(30) Priorität: 07.08.2012 DE 102012015484
(43) Veröffentlichungstag der Anmeldung: 17.06.2015
(73) Patentinhaber: Esselte Leitz GmbH & Co. KG, 70469 Stuttgart (DE)
(72) Erfinder: OLSEN, Arild, 71229 Leonberg (DE); LEUTE, Kurt, 78176 Blumberg (DE); SCHNEIDER, Ulrich, 70563 Stuttgart (DE)
(74) Vertreter: Patentanwälte Bregenzer und Reule Partnerschaftsgesellschaft mbB
(86) Internationale Anmeldenummer: PCT/EP2013/064976
(87) Internationale Veröffentlichungsnummer: WO 2014/023528

(56) Entgegenhaltungen:
- WO-A1-2012/054976
- DE-A1- 4 400 305
- DE-C1- 19 531 866

## Beschreibung

Die Erfindung betrifft eine Haltevorrichtung für einen Tablet-Computer gemäß Oberbegriff des Anspruchs 1.

Tablet-Computer finden eine immer breitere Anwendung, da sie aufgrund ihrer leichten Bauart und ihres Touchscreens einfach zu handhaben sind und auch auf Reisen, wenn wenig Platz zur Verfügung steht, ein Arbeiten am Computer ermöglichen. In der Regel wird der Tablet-Computer vom Benutzer entweder auf eine Tischfläche aufgelegt oder in der Hand gehalten. Dies kann aber unter Umständen unpraktisch oder unbequem sein. Aus der WO 2012/054 976 A1 ist eine Haltevorrichtung der eingangs genannten Art bekannt, die unterschiedliche Positionen des Tablet-Computers mit unterschiedlichen Neigungswinkeln zur Horizontalen ermöglicht.

Es ist daher Aufgabe der Erfindung, eine Haltevorrichtung für einen flachen Gegenstand, wie beispielsweise für einen Tablet-Computer, zu schaffen, die dessen Bedienung vereinfacht.

Diese Aufgabe wird erfindungsgemäß durch eine Haltevorrichtung mit den Merkmalen des Anspruchs 1 gelöst. Vorteilhafte Weiterbildungen der Erfindung sind Gegenstand der abhängigen Ansprüche.

Der Erfindung liegt der Gedanke zugrunde, eine Haltevorrichtung für einen Tablet-Computer zu schaffen, mit der dieser in zwei definierten Positionen auf einer Tischfläche aufgestellt werden kann, so dass seine Bedienung vereinfacht wird. Dabei soll er in der ersten Position, welche durch die erste Auflagefläche definiert wird, stärker gegen die Tischfläche geneigt sein und nahezu hochkant stehen, so dass ein Ablesen vom Bildschirm vereinfacht wird. In der zweiten Position, die durch die zweite Auflagefläche definiert wird, soll er nur gering gegenüber der Tischfläche geneigt sein, also nahezu horizontal angeordnet sein mit einer leichten Neigung zum Benutzer hin, so dass dieser den Touchscreen bequem bedienen und schreiben kann. Eine zusätzliche Funktion bietet die Drehbarkeit des Oberteils gegenüber dem Unterteil. So kann der Tablet-Computer zu Demonstrationszwecken, beispielsweise während einer Besprechung, zu einer anderen Person hin gedreht werden, so dass diese bequem auf seinen Bildschirm schauen kann.

Es wird bevorzugt, dass die erste Auflagefläche, die eine weitgehend aufrechte Positionierung des Tablet-Computers ermöglicht, nicht als durchgehende Fläche ausgebildet ist, sondern zwei im Abstand voneinander angeordnete Partien aufweist. Dabei ist die erste Partie die Innenfläche einer Rinne und die zweite Partie ist in größerer Höhe über der Aufstellfläche angeordnet als die erste Partie. Somit wird der Tablet-Computer mit seiner unteren Kante in der Rinne positioniert und mit seiner Rückseite an die zweite Partie angelehnt. In dieser Position verbleibt er durch die Positionierung der unteren Kante in der Rinne, ohne dass er festgehalten werden muss. Die erste Auflagefläche ist zweckmäßig an die Größe eines handelsüblichen Tablet-Computers angepasst, indem die zweite Partie in einem Abstand von mindestens 45 mm und höchstens 60 mm zur ersten Partie angeordnet ist.

Es wird desweiteren bevorzugt, dass die zweite Auflagefläche durch eine obere Begrenzungsfläche des Oberteils gebildet wird. Der Touchscreen des Tablet-Computers ist dann für Schreibarbeiten leicht zugänglich. Dabei weist die zweite Auflagefläche vorzugsweise ein rutschhemmendes Gummielement auf, so dass der Tablet-Computer in seiner Position liegen bleibt, ohne dass er festgehalten werden muss. Die zweite Auflagefläche ist zweckmäßig auf die Dimensionen eines handelsüblichen Tablet-Computers abgestimmt und weist eine Länge von 50 mm bis 80 mm und eine Breite von 60 mm bis 100 mm auf.

Die Drehbarkeit des Oberteils bezüglich des Unterteils wird bevorzugt mittels eines Kugellagers erreicht, das zwischen dem Oberteil und dem Unterteil einen mit Kugeln versehenen, im Abstand zum Oberteil und zum Unterteil angeordneten Ring aufweist, wobei die Kugeln auf dem Unterteil aufliegen und wobei das Oberteil auf den Kugeln aufliegt. Das Kugellager gewährleistet eine leichtgängige Drehbarkeit des Oberteils bezüglich des Unterteils. Zweckmäßig weisen das Unterteil und das Oberteil jeweils eine rings umlaufende Vertiefung auf, in der die Kugeln aufgenommen sind.

Die Haltevorrichtung weist eine Arretiereinrichtung auf, durch die das Oberteil bezüglich des Unterteils in mindestens einer Vorzugsstellung arretierbar ist. Dadurch wird verhindert, dass sich das Oberteil in unkontrollierter Weise bezüglich des Unterteils dreht. Die Arretiereinrichtung weist zweckmäßig mindestens ein ferromagnetisches Element im Unterteil und mindestens ein ferromagnetisches Element im Oberteil auf, wobei mindestens eines der ferromagnetischen Elemente ein Permanentmagnet ist und wobei in der mindestens einen Vorzugsstellung ein ferromagnetisches Element im Oberteil unter Ausbildung einer magnetischen Anziehungskraft direkt über einem ferromagnetischen Element im Unterteil angeordnet ist. Die magnetische Anziehungskraft muss dann überwunden werden, um das Oberteil bezüglich des Unterteils aus der Vorzugsstellung heraus zu drehen.

Im Folgenden wird die Erfindung anhand eines in der Zeichnung schematisch dargestellten Ausführungsbeispiels näher erläutert. Es zeigen:

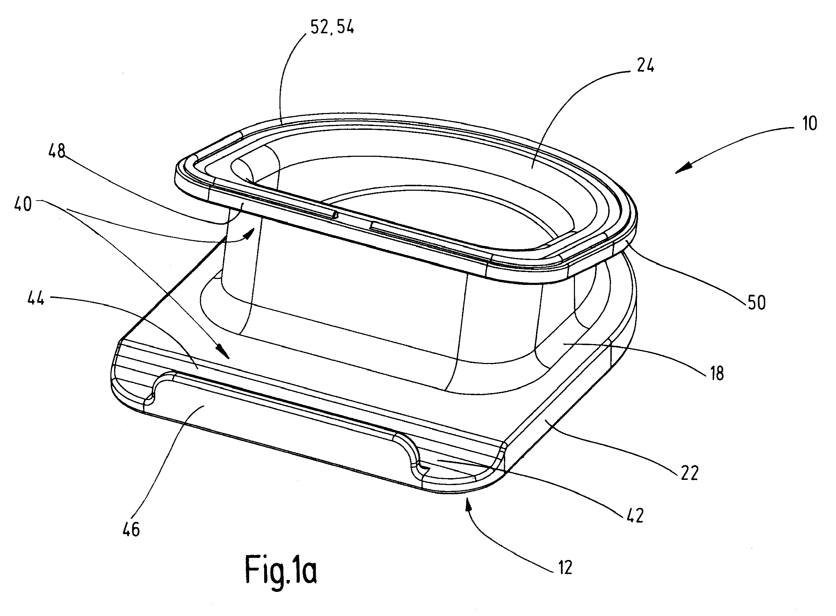

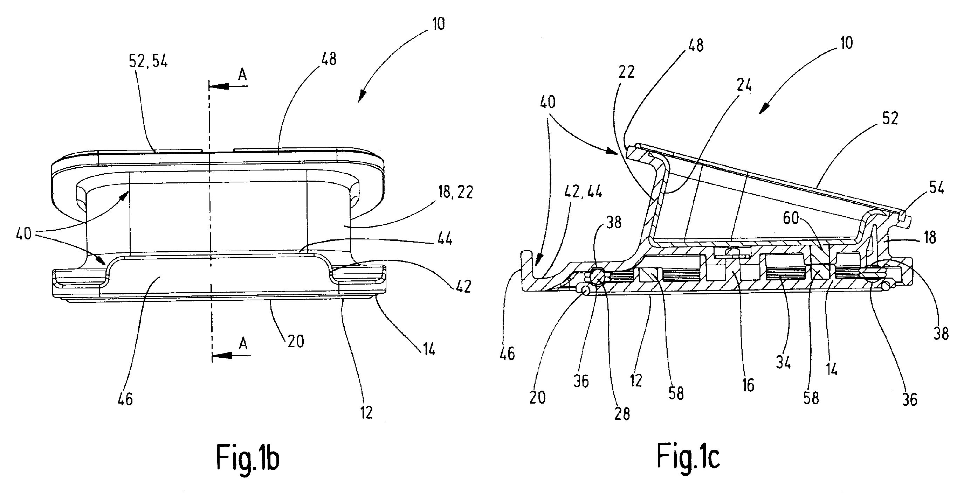

- Fig. 1a bis 1c: eine Haltevorrichtung in perspektivischer Ansicht, in Frontansicht und im Schnitt entlang der Linie A-A;

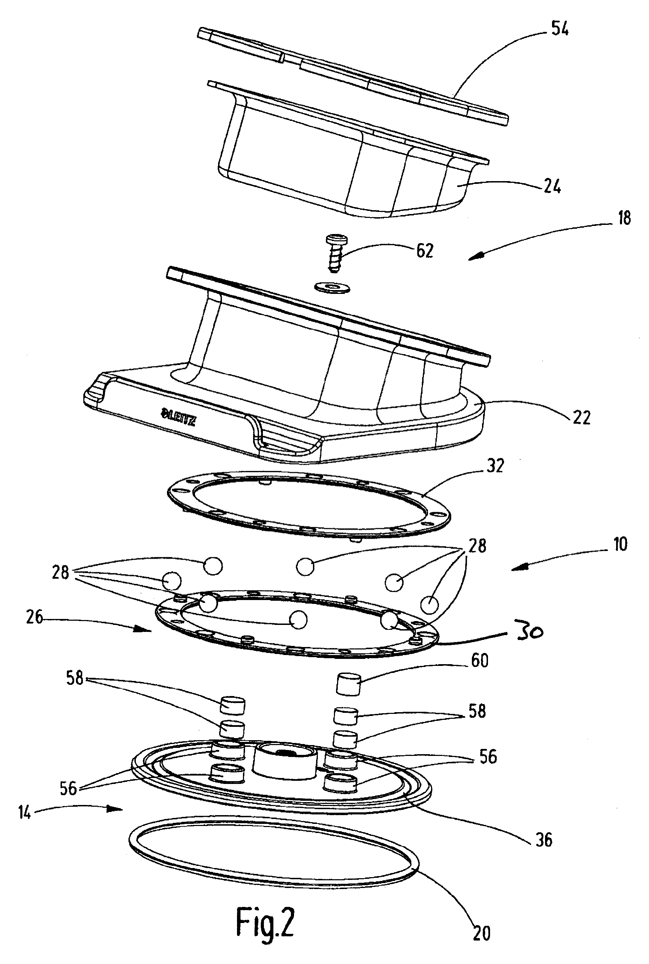

- Fig. 2: eine Explosionsdarstellung der Haltevorrichtung gemäß Fig. 1a bis 1 c und
- Fig. 3a, 3b: die Haltevorrichtung mit einem Tablet-Computer auf der ersten Auflagefläche bzw. auf der zweiten Auflagefläche.

Die in der Zeichnung dargestellte Haltevorrichtung 10 weist ein eine Aufstellfläche 12 zum Aufstellen auf einer Tischfläche aufspannendes Unterteil 14 sowie ein auf dem Unterteil 14 um eine Drehachse 16 drehbar gelagertes Oberteil 18 auf. In der Aufstellfläche 12 ist zudem ein Gummiring 20 eingepaßt, der ein Verrutschen der Haltevorrichtung 10 auf einer Tischfläche verhindern soll. Das Oberteil 18 weist einen Grundkörper 22 und einen in den Grundkörper 22 eingesetzten, die Stabilität des Oberteils 18 erhöhenden Einsatz 24 auf, die jeweils einstückig als Spritzgußteile aus Kunststoff gefertigt sind, ebenso wie das Unterteil 14. Zwischen dem Unterteil 14 und dem Oberteil 18 ist ein Kugellager 26 angeordnet, das im gezeigten Ausführungsbeispiel acht Kugeln 28 aufweist, die in einem Käfig in Form eines aus zwei miteinander verschweißten Teilringen 30, 32 aus Kunststoff zusammengesetzten Rings 34 zwischen den Teilringen 30, 32 aufgenommen sind. Die Kugeln 28 ruhen in einer umlaufenden, kreisförmigen Vertiefung 36 des Unterteils 14, so dass der Ring 34 stets im Abstand zum Unterteil 14 gehalten wird. Auch das Oberteil 18 weist eine kreisförmig umlaufende Vertiefung 38 auf, in die die Kugeln 28 eingreifen, so dass das Oberteil 18 auf den Kugeln 28 ruht und der Ring 34 auch im Abstand zum Oberteil 18 gehalten wird.

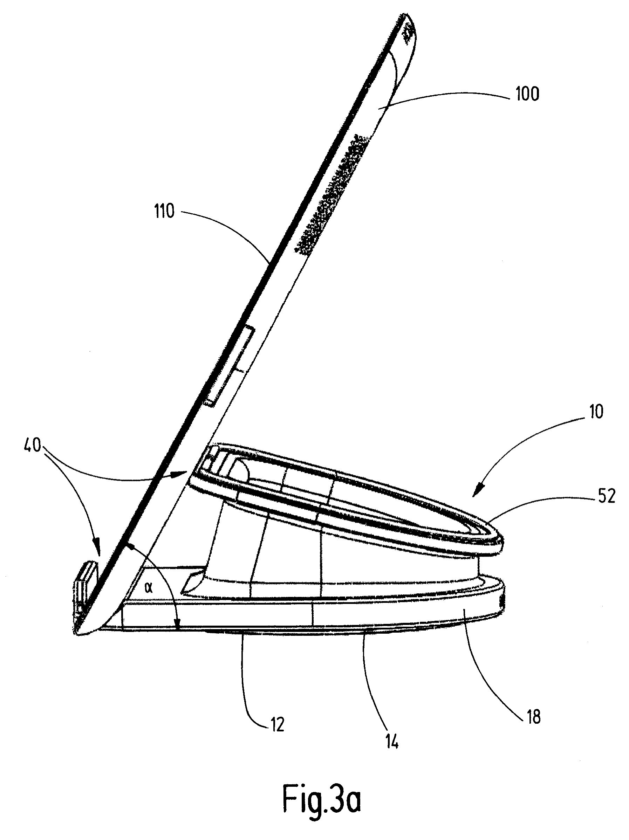

Das Oberteil 18 weist eine erste Auflagefläche 40 für einen Tablet-Computer 100 auf, die sich auf zwei im Abstand voneinander angeordnete Partien aufteilt. Eine erste Partie 42 wird durch die Innenfläche einer Rinne 44 im unteren Bereich des Oberteils 18 gebildet, die auf der der Drehachse 16 abgewandten Seite durch eine vertikal hochstehende Anschlagleiste 46 begrenzt wird. Eine zweite Partie der ersten Auflagefläche 40 wird durch die der Rinne 44 zugewandte Vorderseite 48 eines umlaufenden Rands 50 im oberen Bereich des Oberteils 18 gebildet. Der Tablet-Computer kann so in der Haltevorrichtung 10 aufgenommen werden, dass eine untere Kante in der Rinne 44 aufgenommen ist, während seine Rückseite an der zweiten Partie 48 der ersten Auflagefläche 40 anliegt. Der Tablet-Computer wird dadurch, wie in Fig. 3a gezeigt, in einer ersten Position nahezu aufrecht stehend gehalten, und sein Touchscreen schließt mit der Aufstellfläche 12 einen Winkel α von ca. 60° bis 65° ein.

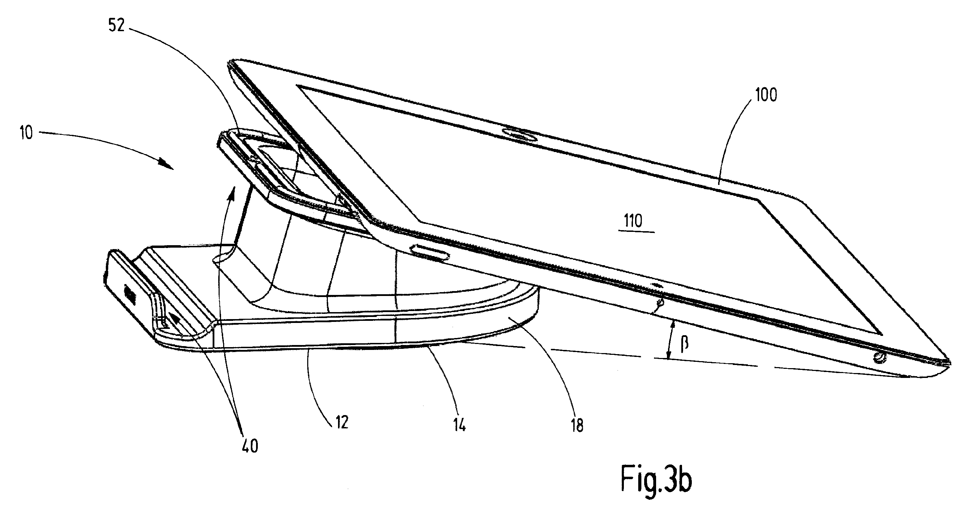

Eine zweite Auflagefläche 52 wird durch eine obere Begrenzungsfläche des Oberteils 18 gebildet, die im vorliegenden Ausführungsbeispiel ein Gummielement 54 aufweist. Die zweite Auflagefläche 52 ist gegenüber der Aufstellfläche 12 um einen Winkel β von ca. 15° geneigt. Auf die zweite Auflagefläche 52 kann der Tablet-Computer 100 in einer zweiten Position aufgelegt werden, wie in Fig. 3b gezeigt. Er ragt dabei so weit herunter, dass seine untere Kante auf der in Fig. 3b nicht gezeigten Tischplatte aufliegt. Es ist aber auch möglich, dass der Tablet-Computer 100 so auf die zweite Auflagefläche 52 aufgelegt wird, dass seine untere Kante im Abstand zur Tischplatte angeordnet ist. Der Touchscreen 110 des Tablet-Computers 100 ist dann gegenüber der Aufstellfläche 12, und damit gegenüber der Tischplatte, nur um den Winkel β von ca. 15 ° geneigt, so dass er leicht bedient werden kann.

Die Abmessungen der Auflageflächen 40, 52 sind dabei auf die Größe des Tablet-Computers 100 abgestimmt. Die erste Auflagefläche 40 ist dadurch charakterisiert, dass die erste Partie 42 und die zweite Partie 48 in einem Abstand von ca. 50 mm zueinander angeordnet sind. Die zweite Auflagefläche 52 weist eine Länge von ca. 65 mm und eine Breite von ca. 75 mm auf.

Das Unterteil 14 ist an seiner Oberseite mit vier in Winkelabständen sowie in gleichen Abständen zur Drehachse 16 angeordneten Aufnahmetaschen 56 versehen, die jeweils einen Permanentmagneten 58 aufnehmen. Desweiteren ist in den Grundkörper 22 des Oberteils 18 ein Permanentmagnet 60 eingesetzt. Alle Magnete 58, 60 weisen mit demselben Pol nach oben, so dass der Magnet 60 im Oberteil 18 eine Anziehungskraft erfährt, wenn er über einem der vier Magneten 58 im Unterteil 14 angeordnet ist. Somit werden vier Vorzugsstellungen des Oberteils 18 bezüglich des Unterteils 14 definiert, aus denen das Oberteil 18 gegenüber dem Unterteil 14 nur durch Aufwenden einer Kraft gedreht werden kann. Das Oberteil 18 ist am Unterteil 14 mittels einer Schraube 62, durch die die Drehachse 16 verläuft, drehbar befestigt, so dass es in axialer Richtung am Unterteil 14 fixiert ist. Es versteht sich von selbst, dass die Permanentmagnete 58 im Unterteil 14 auch durch andere, nicht permanentmagnetische Elemente aus ferromagnetischem Material entsprechender Größe, beispielsweise aus Weicheisen, ersetzt werden können. Alternativ kann auch der Permanentmagnet 60 im Oberteil 18 durch ein anderes, nicht permanentmagnetisches ferromagnetisches Element entsprechender Größe ersetzt werden. In beiden Fällen wird, ebenso wie bei der Ausbildung aller ferromagnetischen Elemente als Permanentmagnete 58, 60, in den Vorzugsstellungen eine magnetische Anziehungskraft erzielt.

Zusammenfassend ist folgendes festzuhalten: Die Erfindung betrifft eine Haltevorrichtung 10 für einen Tablet-Computer 100 mit einem eine Aufstellfläche 12 zum Aufstellen auf eine Tischplatte aufspannenden Unterteil 14 und mit einem um eine im Wesentlichen senkrecht zur Aufstellfläche 12 verlaufende Drehachse 16 bezüglich des Unterteils 14 drehbaren Oberteil 18, welches eine erste und eine zweite Auflagefläche 40, 52 für den Tablet-Computer 100 aufweist, wobei jede der Auflageflächen 40, 52 eine Position des Tablet-Computers 100 definiert, in der er in einem spitzen Winkel α, β zur Aufstellfläche 12 geneigt ist, und wobei der Tablet-Computer 100 in der durch die erste Auflagefläche 40 definierten Position in einem größeren Winkel α zur Aufstellfläche 12 geneigt ist als in der durch die zweite Auflagefläche 52 definierten Position.

## Patentansprüche

1. Haltevorrichtung für einen Tablet-Computer (100) mit einem eine Aufstellfläche (12) zum Aufstellen auf eine Tischplatte aufspannenden Unterteil (14) und mit einem Oberteil (18), welches eine erste und eine zweite Auflagefläche (40, 52) für den Tablet-Computer (100) aufweist, wobei jede der Auflageflächen (40, 52) eine Position des Tablet-Computers (100) definiert, in der er in einem spitzen Winkel (α, β) zur Aufstellfläche (12) geneigt ist, und wobei der Tablet-Computer (100) in der durch die erste Auflagefläche (40) definierten Position in einem größeren Winkel (α) zur Aufstellfläche (12) geneigt ist als in der durch die zweite Auflagefläche (52) definierten Position, **dadurch gekennzeichnet, dass** das Oberteil um eine im Wesentlichen senkrecht zur Aufstellfläche (12) verlaufende Drehachse (16) bezüglich des Unterteils (14) drehbar ist und dass eine Arretiereinrichtung vorgesehen ist, durch die das Oberteil (18) bezüglich des Unterteils (14) in mindestens einer Vorzugsstellung arretierbar ist.

2. Haltevorrichtung nach Anspruch 1, **dadurch gekennzeichnet, dass** die erste Auflagefläche (40) zwei im Abstand voneinander angeordnete Partien (42, 48) aufweist, von denen eine erste Partie (42) die Innenfläche einer Rinne (44) ist und die zweite Partie (48) in größerer Höhe über der Aufstellfläche (12) angeordnet ist als die erste Partie (42).

3. Haltevorrichtung nach Anspruch 2, **dadurch gekennzeichnet, dass** die zweite Partie (48) in einem Abstand von mindestens 45 mm und höchstens 60 mm zur ersten Partie (42) angeordnet ist.

4. Haltevorrichtung nach einem der vorangehenden Ansprüche, **dadurch gekennzeichnet, dass** die zweite Auflagefläche (52) durch eine obere Begrenzungsfläche des Oberteils (18) gebildet wird.

5. Haltevorrichtung nach einem der vorangehenden Ansprüche, **dadurch gekennzeichnet, dass** die zweite Auflagefläche (52) ein rutschhemmendes Gummielement (54) aufweist.

6. Haltevorrichtung nach Anspruch 4 oder 5, **dadurch gekennzeichnet, dass** die zweite Auflagefläche (52) eine Länge von 50 mm bis 80 mm und eine Breite von 60 mm bis 100 mm aufweist.

7. Haltevorrichtung nach einem der vorangehenden Ansprüche, **gekennzeichnet durch** ein Kugellager (26), das zwischen dem Oberteil (18) und dem Unterteil (14) einen mit Kugeln (28) versehenen, im Abstand zum Oberteil (18) und zum Unterteil (14) angeordneten Ring (34) aufweist, wobei die Kugeln (28) auf dem Unterteil (14) aufliegen und wobei das Oberteil (18) auf den Kugeln (28) aufliegt.

8. Haltevorrichtung nach Anspruch 7, **dadurch gekennzeichnet, dass** das Unterteil (14) und das Oberteil (18) jeweils eine rings umlaufende Vertiefung (36, 38) aufweisen, in der die Kugeln (28) aufgenommen sind.

9. Haltevorrichtung nach einem der vorangehenden Ansprüche, **dadurch gekennzeichnet, dass** die Arretiereinrichtung mindestens ein ferromagnetisches Element (58) im Unterteil (14) und mindestens ein ferromagnetisches Element (60) im Oberteil (18) aufweist, wobei mindestens eines der ferromagnetischen Elemente (58, 60) ein Permanentmagnet ist, und dass in der mindestens einen Vorzugsstellung ein ferromagnetisches Element (60) im Oberteil (18) unter Ausbildung einer magnetischen Anziehungskraft direkt über einem ferromagnetischen Element (58) im Unterteil (14) angeordnet ist.

## Claims

1. Holding device for a tablet computer (100) having a lower part (14) spanning an installation surface (12) for installation on a table top and having an upper part (18) which has a first and a second contact area (40, 52) for the tablet computer (100), whereby each of the contact areas (40, 52) defines a position of the tablet computer (100) in which it is inclined at an acute angle (α, β) to the installation surface (12) and whereby the tablet computer (100) in the position defined by the first support position (40) is inclined to the installation surface (12) at a greater angle (α) than in the position defined by the second contact area (52), **characterised in that** the upper part is rotatable about an axis of rotation (16) running substantially perpendicularly to the installation surface (12) relative to the lower part (14) and **in that** a locking device is provided so that the upper part (18) can be locked relative to the lower part (14) in at least one preferential position.

2. Holding device according to claim 1, **characterised in that** the first contact area (40) has two parts (42, 48) arranged at a distance from one another, a first part (42) of which is the inner surface of a channel (44) and the second part (48) of which is arranged higher above the installation surface (12) than the first part (42).

3. Holding device according to claim 2, **characterised in that** the second part (48) is arranged at a distance of at least 45 mm and no more than 60 mm from the first part (42).

4. Holding device according to any one of the preceding claims, **characterised in that** the second contact area (52) is formed by an upper boundary surface of the upper part (18).

5. Holding device according to any one of the preceding claims, **characterised in that** the second contact area (52) has an anti-slip rubber element (54).

6. Holding device according to either claim 4 or claim 5, **characterised in that** the second contact area (52) has a length of 50 mm to 80 mm and a width of 60 mm to 100 mm.

7. Holding device according to any one of the preceding claims, **characterised by** a ball bearing (26) having a ring (34) with balls (28) arranged between the upper part (18) and the lower part (14) at a distance from the upper part (18) and the lower part (14), whereby the balls (28) lie on the lower part (14) and whereby the upper part (18) lies on the balls (28).

8. Holding device according to claim 7, **characterised in that** the lower part (14) and the upper part (18) each have a circumferential recess (36, 38) which receives the balls (28).

9. Holding device according to any one of the preceding claims, **characterised in that** the locking device has at least one ferromagnetic element (58) in the lower part (14) and at least one ferromagnetic element (60) in the upper part (18), whereby at least one of the ferromagnetic elements (58, 60) is a permanent magnet, and **in that** in the at least one preferential position a ferromagnetic element (60) in the upper part (18) is arranged directly above a ferromagnetic element (58) in the lower part (14), generating magnetic attraction.

## Revendications

1. Dispositif de maintien destiné à une tablette électronique (100), comprenant une partie inférieure (14) délimitant une surface d'assise (12), en vue de la mise en place sur un plateau de table, et une partie supérieure (18) munie de première et seconde surfaces d'appui (40, 52) affectées à ladite tablette électronique (100), chacune desdites surfaces d'appui (40, 52) définissant un emplacement de ladite tablette électronique (100) auquel cette dernière est inclinée en décrivant un angle aigu (α, β) par rapport à ladite surface d'assise (12), sachant qu'à l'emplacement défini par la première surface d'appui (40), ladite tablette électronique (100) est inclinée, par rapport à ladite surface d'assise (12), en décrivant un angle (α) plus grand qu'à l'emplacement défini par la seconde surface d'appui (52), **caractérisé par le fait que** la partie supérieure peut tourner, par rapport à la partie inférieure (14), autour d'un axe de rotation (16) s'étendant pour l'essentiel perpendiculairement à la surface d'assise (12) ; et **par le fait qu'**il est prévu un système d'arrêt, par lequel ladite partie supérieure (18) peut être arrêtée dans au moins une position favorite par rapport à ladite partie inférieure (14).

2. Dispositif de maintien selon la revendication 1, **caractérisé par le fait que** la première surface d'appui (40) comporte deux régions (42, 48) placées à distance l'une de l'autre, parmi lesquelles une première région (42) constitue la face intérieure d'une rainure (44) et la seconde région (48) est située, au-dessus de la surface d'assise (12), à une plus grande hauteur que ladite première région (42).

3. Dispositif de maintien selon la revendication 2, **caractérisé par le fait que** la seconde région (48) se trouve à une distance de 45 mm au minimum, et de 60 mm au maximum par rapport à la première région (42).

4. Dispositif de maintien selon l'une des revendications précédentes, **caractérisé par le fait que** la seconde surface d'appui (52) est formée par une surface supérieure de délimitation de la partie supérieure (18).

5. Dispositif de maintien selon l'une des revendications précédentes, **caractérisé par le fait que** la seconde surface d'appui (52) est pourvue d'un élément en caoutchouc (54) antidérapant.

6. Dispositif de maintien selon la revendication 4 ou 5, **caractérisé par le fait que** la seconde surface d'appui (52) présente une longueur de 50 mm à 80 mm, et une largeur de 60 mm à 100 mm.

7. Dispositif de maintien selon l'une des revendications précédentes, **caractérisé par** un roulement (26) à billes comportant, entre la partie supérieure (18) et la partie inférieure (14), un anneau (34) pourvu de billes (28) et placé à distance de ladite partie supérieure (18) et de ladite partie inférieure (14), les billes (28) reposant sur ladite partie inférieure (14), et ladite partie supérieure (18) reposant sur lesdites billes (28).

8. Dispositif de maintien selon la revendication 7, **caractérisé par le fait que** la partie inférieure (14) et la partie supérieure (18) sont respectivement dotées d'un renfoncement (36, 38) à étendue périphérique, dans lequel les billes (28) sont logées.

9. Dispositif de maintien selon l'une des revendications précédentes, **caractérisé par le fait que** le système d'arrêt comprend au moins un élément ferromagnétique (58) dans la partie inférieure (14), et au moins un élément ferromagnétique (60) dans la partie supérieure (18), au moins l'un desdits éléments ferromagnétiques (58, 60) étant un aimant permanent ; et **par le fait que**, dans la position favorite à présence minimale, un élément ferromagnétique (60) situé dans ladite partie supérieure (18) est placé directement au-dessus d'un élément ferromagnétique (58) situé dans ladite partie inférieure (14), en exerçant une force d'attraction magnétique.
